# EUROPEAN PATENT APPLICATION

(11) **EP 1 603 144 A1**
(43) Date of publication of application: **07.12.2005**
(21) Application number: 04716699.6
(22) Date of filing: 03.03.2004
(51) Int. Cl.: H01G 4/40, H01G 4/255, H01G 2/24, H01F 17/00, H01F 27/00

(54) **COMPOSITE ELECTRONIC COMPONENT**

(30) Priority: 31.03.2003 JP 2003094966
(71) Applicant: MATSUSHITA ELECTRIC INDUSTRIAL CO., LTD., Kadoma-shi, Osaka 571-8501 (JP)
(72) Inventor: KAWAJIRI, Keiji, Hokkaido 061-1374 (JP); OKIMOTO, Tomohisa, Hokkaido 061-1127 (JP); KOGA, Eiichi, Hokkaido 053-0831 (JP)
(74) Representative: Grünecker, Kinkeldey, Stockmair & Schwanhäusser Anwaltssozietät
(86) International application number: PCT/JP2004/002595
(87) International publication number: WO 2004/088688

(57) **Abstract**

A composite electronic component which can adjust a capacitance obtained due to an overlap of inner layer capacitor electrode parts sandwiching dielectric sheets by changing an overlapping area of the inner layer capacitor electrode parts, and in which an identification mark has been provided lower than a height of an external electrode of a laminated body, whereby an adjustment of an electric capacitance is easy and, by the fact that the identification mark does not protrude, a mounting performance when the composite electronic component is mounted by being sucked by a suction nozzle is improved.

## Description

### Technical Field

The present invention relates to a composite electronic component.

### Background Art

A conventional composite electronic component has possessed a direction identification mark at a part other than a center portion of a laminated body such that an end face or a side face of the laminated body can be defined in an outermost layer of the laminated body. As disclosed in Japanese Patent Unexamined Publication No.2000-353620, this direction identification mark has been formed by printing a resin or an electric conductor, and has protruded from a face of the outermost layer of the laminated body.

The smaller a shape of the composite electronic component becomes, the more the printed direction identification mark is liable to deviate from a predetermined place. Further, when the composite electronic component having the direction identification mark deviated from the predetermined place is mounted to a mounting substrate by being sucked by a suction nozzle and the like, since the direction identification mark protrudes on the outermost layer, there has been a problem that it cannot be sucked by the suction nozzle. As a countermeasure for it, if the direction identification mark is thinly formed, by the fact that the direction identification mark is removed when grinding a barrel in order to prevent a corner of a chip component from chipping, there has been a problem that a direction identification mounting becomes impossible when mounting a chip.

### Disclosure of the Invention

A composite electronic component of the present invention is one which adjusts a capacitance obtained as an overlap of inner layer capacitor parts sandwiching dielectric sheets by changing an overlapping area of the inner layer capacitor parts. Further, since an identification mark can be provided lower than a height of an external electrode of the laminated body, the identification mark does not protrude from an outermost layer of the composite electronic component, so that a mounting performance when the composite electronic component is mounted by being sucked by the suction nozzle can be improved.

### Brief Description of the Drawings

Fig. 1 is a perspective view of a composite electronic component in one exemplary embodiment of the present invention.
Fig. 2 is a perspective view in which one part of the composite electronic component in one exemplary embodiment of the present invention has been cut away.
Fig. 3 is an exploded perspective view of the composite electronic component in one exemplary embodiment of the present invention.
Fig. 4A is an explanatory view of a main part of the composite electronic component in one exemplary embodiment of the present invention.
Fig. 4B is a sectional view along X3 - X4 line in Fig. 4A.
Fig. 4C is a sectional view along Y3 - Y4 line in Fig. 4A.
Fig. 5A is an explanatory view of a main part of the composite electronic component in other exemplary embodiment of the present invention.
Fig. 5B is a sectional view along X3 - X4 line in Fig. 5A.
Fig. 5C is a sectional view along a Y3 - Y4 line in Fig. 5A.
Fig. 6A is an explanatory view of a main part of the composite electronic component in a still other exemplary embodiment of the present invention.
Fig. 6B is a sectional view along X3 - X4 line in Fig. 6A.
Fig. 6C is a sectional view along Y3 - Y4 line in Fig. 6A.
Fig. 7A is an explanatory view of a main part of the composite electronic component in a still other exemplary embodiment of the present invention.
Fig. 7B is a sectional view along X3 - X4 line in Fig. 6A.
Fig. 7C is a sectional view along Y3 - Y4 line in Fig. 6A.

### Best Mode for Carrying Out the Invention

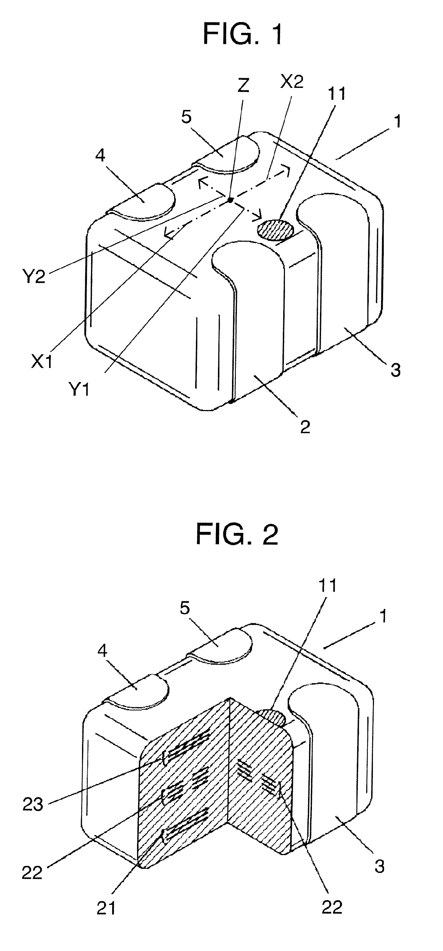

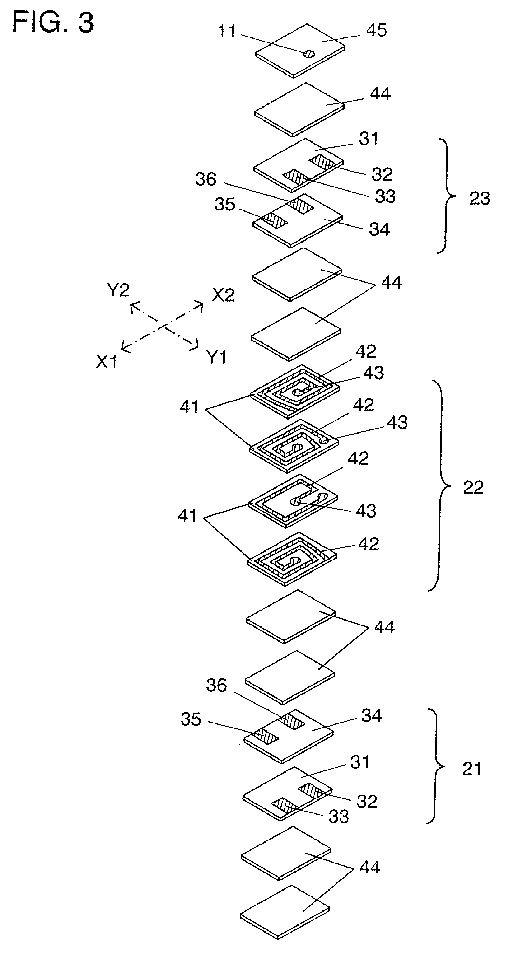

A composite electronic component in one exemplary embodiment of the present invention is explained referring to the drawings. In Figs. 1 and 3, in order to clearly show positional relations, there are indicated longitudinal directions X1 and X2, width directions Y1 and Y2, and center part Z.

As shown in Fig. 1, Fig. 2 and Fig. 3, the composite electronic component in the present exemplary embodiment possesses laminated body 1, first external electrode 2 and second external electrode 3, which have been provided over an upper face, a side face and a bottom face in a Y1 direction side of an outermost layer of laminated body 1, third external electrode 4 and fourth external electrode 5, which have been provided over the upper face, the side face and the bottom face in a Y2 direction side of the outermost layer, and identification mark 11.

Here, third external electrode 4 and fourth external electrode 5 are oppositely formed to first external electrode 2 and second external electrode 3 respectively with respect to longitudinal direction X1 - X2 and laminated body 1 is sandwiched between the opposed electrodes. Further, identification mark 11 is formed at the upper face of laminated body 1, its height is lower than those of first, second, third and fourth external electrodes 2, 3, 4 and 5, and is provided in the same plane (in the same plane and in the same height) as the outermost layer of laminated body 1.

Laminated body 1 possesses, in its inside, first capacitor part 21, inductor part 22 and second capacitor part 23 from its bottom face side.

First capacitor part 21 is a laminated structure of first dielectric sheet 31 and second dielectric sheet 34, which consist of a glass ceramic and the like. First dielectric sheet 31 has, on its upper face, first inner layer capacitor electrode part 32 and second inner layer capacitor electrode part 33, which are formed by printing and include Ag, Cu or the like, from an end part toward a center part of a width direction Y1 side. First dielectric sheet 31 has, on its upper part, second dielectric sheet 34 consisting of the same constituent as first dielectric sheet 31. This second dielectric sheet 34 has, on its upper face, third inner layer capacitor electrode part 35 and fourth inner layer capacitor electrode part 36, which are formed by printing and consist of Ag, or Cu or the like, from an end part toward a center part of a width direction Y2 side. First inner layer capacitor electrode part 32 and fourth inner layer capacitor electrode part 36 as well as second inner layer capacitor electrode part 33 and third inner layer capacitor electrode part 35 are respectively provided oppositely each other through second dielectric sheet 34 and, by adjusting an area (overlapping amount) of an overlapping portion, it is possible to obtain a desired capacitance of the capacitor.

Next, inductor part 22 is provided in an upper part of first capacitor part 21, and consists of plural third dielectric sheets 41 on which there have been printed spiral internal conductors 42 consisting of Ag, Cu or the like. These spiral internal conductors 42 are electrically connected through via electrodes 43 provided in dielectric sheets 41. By setting the number of dielectric sheets 41 having these spiral internal conductors 42, the number of spirals, or a line width of internal conductor 42 and the like, it is possible to obtain a desired inductance value.

Further, in order to adjust a stray capacitance between inductor part 22 and third inner layer capacitor electrode part 35 or fourth inner layer capacitor electrode part 36, fourth dielectric sheet 44 consisting of glass ceramic may be provided in one piece or plural pieces.

Further, from first dielectric sheet 31 toward an outermost layer side (lower part of Fig. 3), fourth dielectric sheet 44 is provided in plural pieces.

Second capacitor part 23 has a constitution similar to first capacitor part 21, and is provided in an upper face of inductor part 22. The same reference numeral is applied to a portion of a component similar to first capacitor part 21, and its explanation is omitted.

As shown in Figs. 1 and 2, first external electrode 2 electrically connects second inner layer capacitor electrode part 33 of first capacitor part 21, one spiral internal conductor 42 of inductor part 22, and second inner layer capacitor electrode part 33 of second capacitor part 23. Second external electrode 3 electrically connects first inner layer capacitor electrode part 32 of first capacitor part 21, other spiral internal conductor 42 of inductor part 22, and first inner layer capacitor electrode part 32 of second capacitor part 23. Third external electrode 4 electrically connects third inner layer capacitor electrode part 35 of first capacitor part 21, and third inner layer capacitor electrode part 35 of second capacitor 23. Additionally, fourth external electrode 5 electrically connects fourth inner layer capacitor electrode part 36 of first capacitor part 21, and fourth inner layer capacitor electrode part 36 of second capacitor 23.

Further, identification mark 11 is made in the same face and in the same depth as fifth dielectric sheet 45 by using a glass whose main constituent is the same as fifth dielectric sheet 45. By making identification mark 11 while deviating from center part Z of laminated body 1, an end face or the side face of laminated body 1 can be defined. That is, a side in which there has been provided identification mark 11, i.e., a face having the nearest side among four sides of laminated body 1 when seen from a top face, can be identified as the end face showing a desired direction. In one exemplary embodiment of the present invention shown in Fig. 1, since identification mark 11 is provided in Y1 side, the fact can be identified that inductor part 22 is connected to the external electrodes in Y1 side, i.e., first external electrode 2 and second external electrode 3. Among the four sides of laminated body 1, the face having the nearest side from a position in which identification mark 11 has been provided can be identified as the end face showing the desired direction.

Further, although one exemplary embodiment of the present invention has been explained using circular identification mark 11, the identification mark in the present invention is not limited to the circular shape, and may be constituted by an arbitrary shape.

As to the composite electronic component constituted like the above, hereunder it is explained about a capacitance adjustment of its capacitor part while referring to the drawings.

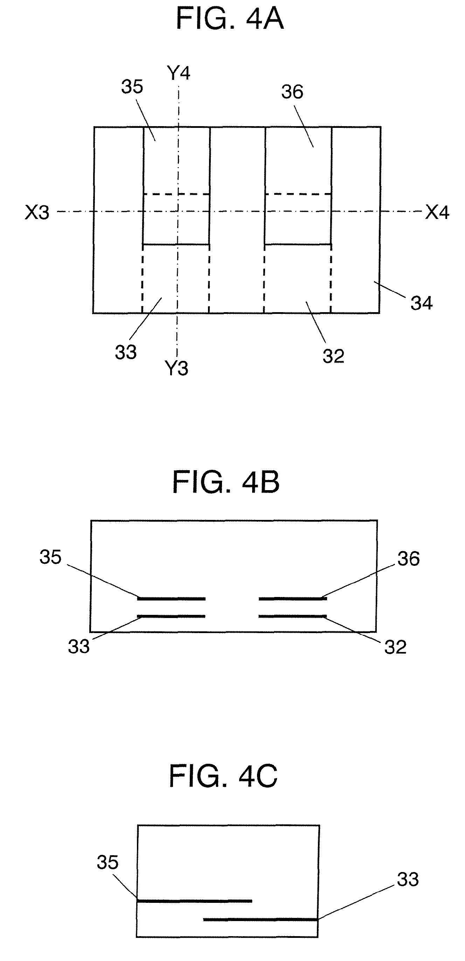

Fig. 4A explains an overlap between first inner layer capacitor electrode part 32 and fourth inner layer capacitor electrode part 36 and an overlap between second inner layer capacitor electrode part 33 and third inner layer capacitor electrode part 35 in first capacitor part 21 that is a main part of the composite electronic component in one exemplary embodiment of the present invention. Fig. 4B shows a sectional view along an X3 - X4 line in Fig. 4A. Fig. 4C is a sectional view along a Y3 - Y4 line in Fig. 4A.

As shown in Figs. 4A - 4C, a capacitance of first capacitor part 21 that is the main part of the composite electronic component is determined in compliance with an overlapping area between first inner layer capacitor electrode part 32 and fourth inner layer capacitor electrode part 36 and an overlapping area between second inner layer capacitor electrode part 33 and third inner layer capacitor electrode part 35.

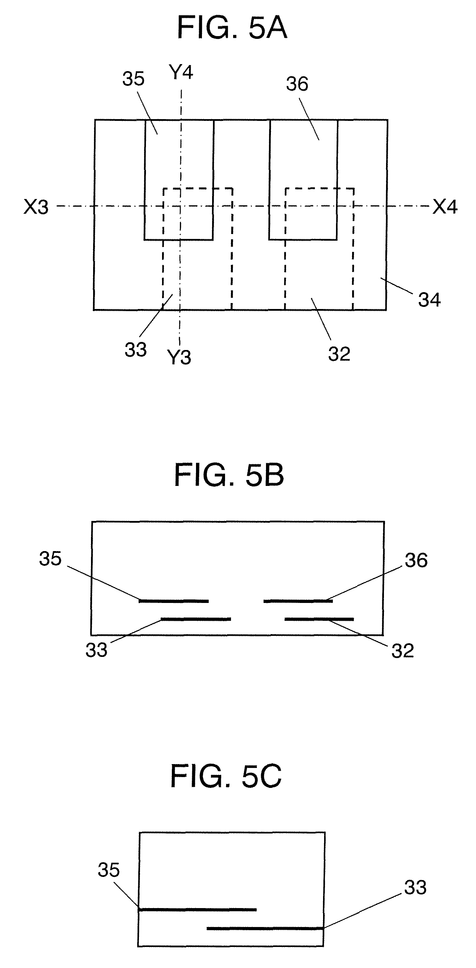

As shown in one embodiment of Figs. 5A - 5C, by shifting third inner layer capacitor electrode part 35 and fourth inner layer capacitor electrode part 36 with respect to first inner layer capacitor electrode part 32 and second inner layer capacitor electrode part 33 respectively, it is possible to change the overlapping area between the electrodes. By doing like this, it is possible to arbitrarily adjust, within a small range, a capacitance of first capacitor part 21 with respect to a capacitance shown in Figs. 4A - 4C.

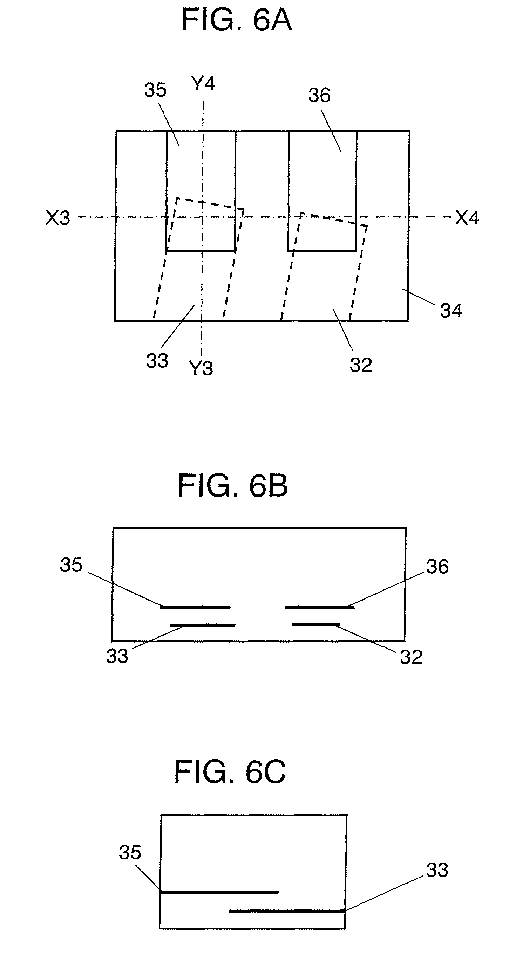

Figs. 6A - 6C, show other embodiment concerning the exemplary embodiment of the present invention. By slanting third inner layer capacitor electrode part 35 and fourth inner layer capacitor electrode part 36 against first inner layer capacitor electrode part 32 and second inner layer capacitor electrode part 33, it is possible to change the overlapping area between the electrodes. Even if constituted like this, it is possible to arbitrarily adjust, within the small range, the capacitance of first capacitor part 21 with respect to the capacitance shown in Figs. 4A - 4C.

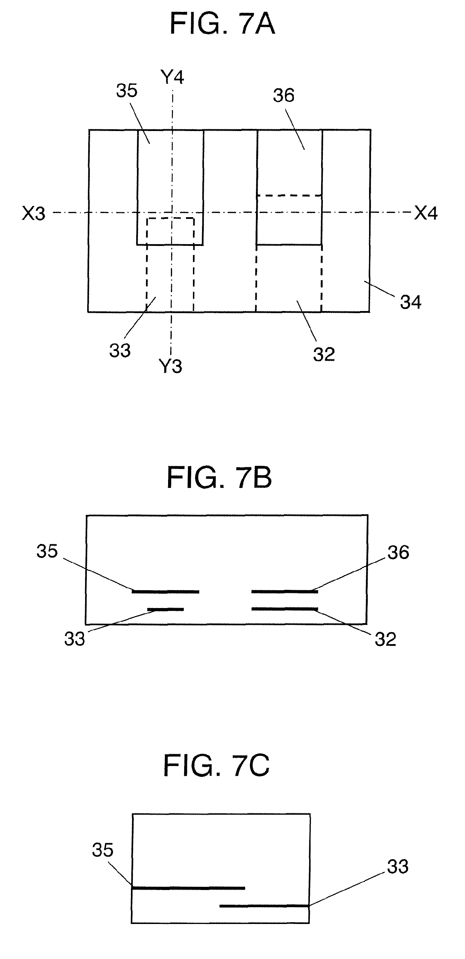

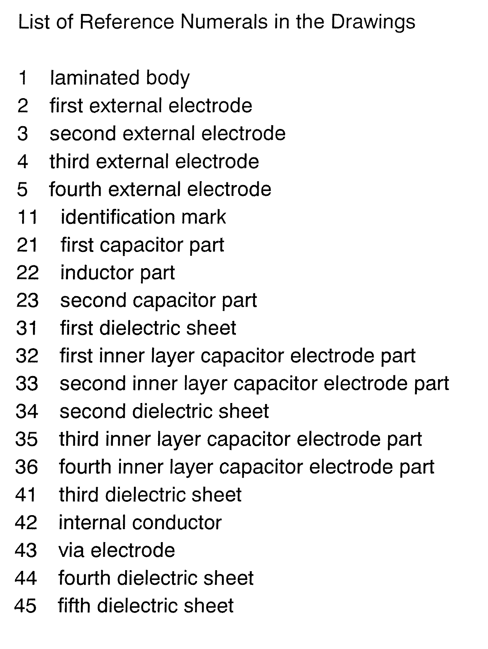

Next, a still other embodiment concerning the exemplary embodiment of the present invention is explained by using Figs. 7A - 7C. That is, it is a constitution in which the capacitance adjustment of capacitor part 21 is performed by causing, between the inner layer capacitor electrode parts overlapping above and below, a width or a length of one electrode to differ from the other electrode. In Fig. 7A, there has been shown an example in which, by changing the width and the length of second inner layer capacitor electrode part 33, it has been made smaller than the area of third inner layer capacitor electrode part 35. Since the present means can be applied to every overlapping electrode, it is possible to accurately perform the capacitance adjustment.

In the above exemplary embodiment, although the means for adjusting the capacitance of first capacitor part 21 has been explained, it is needless to say that the present exemplary embodiment can be applied also to second capacitor part 23. That is, the present invention can be applied to only any one of first capacitor part 21 and second capacitor part 23, or can be simultaneously applied to both.

As explained above, the composite electronic component of the present invention can adjust the capacitance obtained by the overlap of the inner layer capacitor parts sandwiching the dielectric sheets, by changing the overlapping area of the inner layer capacitor parts.

Further, since the identification mark can be provided lower than the height of the external electrodes of the laminated body, the identification mark does not protrude from the outermost layer of the composite electronic component. Bythis, the mounting performance when the composite electronic component is mounted by being sucked by the suction nozzle can be improved.

Further, since the identification mark is embedded in the outermost layer of the laminated body to thereby be provided in the same plane as the outermost layer, and the outermost layer of the laminated body and the identification mark are constituted by the glass whose main constituent is the same material, even if it is thinned, a lack of the identification mark does not occur, and a productivity for mounting while identifying the direction can be improved.

### Industrial Applicability

The present invention is one which provides the composite electronic component whose mounting property when mounted by being sucked by the suction nozzle is good, and which can adjust the capacitance of the capacitor part by the simple method.

## Claims

1. A composite electronic component comprising:
a laminated body having in its inside an inductor part and a capacitor part,
external electrodes formed on outer faces of the laminated body and electrically connecting the inductor part and the capacitor part, and
an identification mark showing a direction of the laminated body,
wherein a height of the identification mark is lower than a height of the external electrode,
the capacitor part has dielectric layers, and at least one pair of inner layer capacitor electrodes opposed to each other through the dielectric layers, and
a capacitance of the capacitor part is adjusted by adjusting an opposed area of the one pair of inner layer capacitor electrodes.

2. The composite electronic component of claim 1, wherein the identification mark is formed at the same plane and in the same height as an outermost layer of the laminated body.

3. The composite electronic component of claim 1, wherein an outermost layer of the laminated body and the identification mark consist of a glass whose main constituent is the same material.

4. The composite electronic component of claim 1, wherein the capacitor parts have a first capacitor part and a second capacitor part, and the inductor part is disposed between the first capacitor part and the second capacitor part.

5. The composite electronic component of claim 1, wherein the one pair of inner layer capacitor electrodes include a first inner layer capacitor electrode consisting of a first rectangle and a second inner layer capacitor electrode consisting of a second rectangle, and
the opposed area is adjusted by shortening at least one side of a long side and a short side of the first rectangle and the second rectangle.

6. The composite electronic component of claim 1, wherein the one pair of inner layer capacitor electrodes include a first inner layer capacitor electrode consisting of a first rectangle and a second inner layer capacitor electrode consisting of a second rectangle, and
the first rectangle and the second rectangle are the same shape and the opposed area is adjusted by slanting a long side direction at a predetermined angle.

7. The composite electronic component of claim 1, wherein the one pair of inner layer capacitor electrodes include a first inner layer capacitor electrode consisting of a first rectangle and a second inner layer capacitor electrode consisting of a second rectangle, and
the first rectangle and the second rectangle are a similar figure and the opposed area is adjusted by making the first rectangle smaller than the second rectangle.

8. A method of manufacturing a composite electronic component including:
a laminated body having in its inside an inductor part and a capacitor part,
external electrodes formed in outer faces of the laminated body and electrically connecting the inductor part and the capacitor part, and
an identification mark showing a direction of the laminated body,
the method of manufacturing the capacitor part including a process of laminating dielectric sheets on whose one face there have been formed inner layer capacitor electrodes, wherein the laminating process includes a process of adjusting an overlap of the inner layer capacitor electrodes formed on adjoining dielectric sheets.

9. The method of manufacturing a composite electronic component of claim 8, wherein the identification mark is formed in the same thickness as the dielectric sheet constituting an outermost layer of the laminated body.

10. The method of manufacturing a composite electronic component of claim 8, wherein the dielectric sheet of an outermost layer and the identification mark are made by using a glass whose main constituent is the same material.

11. The method of manufacturing a composite electronic component of claim 8, wherein the inductor part is sandwiched by the capacitor parts.

12. The method of manufacturing a composite electronic component of claim 8, wherein the process of adjusting an overlap of the inner layer capacitor electrodes is an operation of moving one of the dielectric sheets in a longitudinal direction of the laminated body.

13. The method of manufacturing a composite electronic component of claim 8, wherein the process of adjusting an overlap of the inner layer capacitor electrodes is an operation of slanting the dielectric sheets each other in a longitudinal direction of the laminated body.

14. The method of manufacturing a composite electronic component of claim 8, wherein the process of adjusting an overlap of the inner layer capacitor electrodes includes a process of forming the inner layer capacitor electrodes on the adjoining dielectric sheets into different patterns each other.
